# EUROPEAN PATENT APPLICATION

(11) **EP 4 325 563 A2**
(43) Date of publication of application: **21.02.2024**
(21) Application number: 23185275.7
(22) Date of filing: 13.07.2023
(51) Int. Cl.: H01L 23/522

(54) **SEMICONDUCTOR DEVICES WITH A STRUCTURE CAPABLE OF SUPPRESSING COUPLING NOISE SUPPRESSION**

(30) Priority: 26.07.2022 US 202263369394 P; 19.06.2023 US 202318211551
(71) Applicant: MediaTek Inc., Hsin-Chu 300 (TW)
(72) Inventor: LI, Po-Jui, 30078 Hsinchu City (TW); SUN, Ruey-Bo, 30078 Hsinchu City (TW); LU, Yen-Ju, 30078 Hsinchu City (TW); YEH, Chun-Yuan, 30078 Hsinchu City (TW); LIN, Sheng-Mou, 30078 Hsinchu City (TW)
(74) Representative: Hoefer & Partner Patentanwälte mbB

(57) **Abstract**

A semiconductor device (100) includes an electronic device (110), a guard trace (120) and a first trace (T1). The guard trace (120) is connecting to a ground layer through a first ground via (G_Via_11). The first trace (T1) is disposed adjacent to the electronic device (110) and the guard trace (120) and includes a first segment. A phase or a direction of a first current signal conducted on the first trace (T1) is changed in the first segment. The electronic device (110) and the first trace (T1) are disposed at different sides of the guard trace (120) and the first ground via (G_Via_11) is beside the first segment.

## Description

### Cross Reference to Related Applications

This application claims the benefit of U.S. Provisional Application No. 63/369,394, filed on July 26th, 2022. The content of the application is incorporated herein by reference.

### Background

On-chip inductor is a general element frequently used in semiconductor devices, but it is a very sensitive block which is easily interfered by coupling noises of other aggressors. The aggressors might be on-chip, package, or PCB circuits or layout routings. Moving the aggressor far away is a known solution, but it will make larger chip area, which leads to higher cost.

Therefore, a new solution deploying to the semiconductor device structure being effective for the suppression of the coupling noise is highly required.

### Summary

Semiconductor devices according to the invention are defined in the independent claims. The dependent claims define preferred embodiments thereof. According to an embodiment of the invention, a semiconductor device comprises an electronic device, a guard trace and a first trace. The guard trace is connecting to a ground layer through a first ground via. The first trace is disposed adjacent to the electronic device and the guard trace and comprises a first segment. A phase or a direction of a first current signal conducted on the first trace is changed in the first segment. The electronic device and the first trace are disposed at different sides of the guard trace and the first ground via is beside the first segment.

According to another embodiment of the invention, a semiconductor device comprises an inductor, a guard trace and a differential circuit. The guard trace is connecting to a ground layer through a first ground via. The differential circuit is disposed adjacent to the inductor and the guard trace and comprises a first segment. A phase or a direction of a first current signal conducted in the differential circuit is changed in the first segment. The inductor and the differential circuit are disposed at different sides of the guard trace, the guard trace extends along a first direction, and the first ground via is arranged aside the first segment along a second direction substantially perpendicular to the first direction.

These and other objectives of the present invention will no doubt become obvious to those of ordinary skill in the art after reading the following detailed description of the preferred embodiment that is illustrated in the various figures and drawings.

### Brief Description of the Drawings

FIG. 1 illustrates an exemplary top view of a semiconductor device according to an embodiment of the invention.
FIG. 2 is a drawing of partial enlargement of a top view of the aggressor device having a twisted structure to suppress the coupling noise induced thereby according to an embodiment of the invention.
FIG. 3 illustrates an exemplary top view of a semiconductor device according to another embodiment of the invention.
FIG. 4 illustrates an exemplary top view of a semiconductor device according to yet another embodiment of the invention.
FIG. 5 illustrates an exemplary top view of a semiconductor device according to yet another embodiment of the invention.
FIG. 6 illustrates an exemplary top view of a semiconductor device according to yet another embodiment of the invention.

### Detailed Description

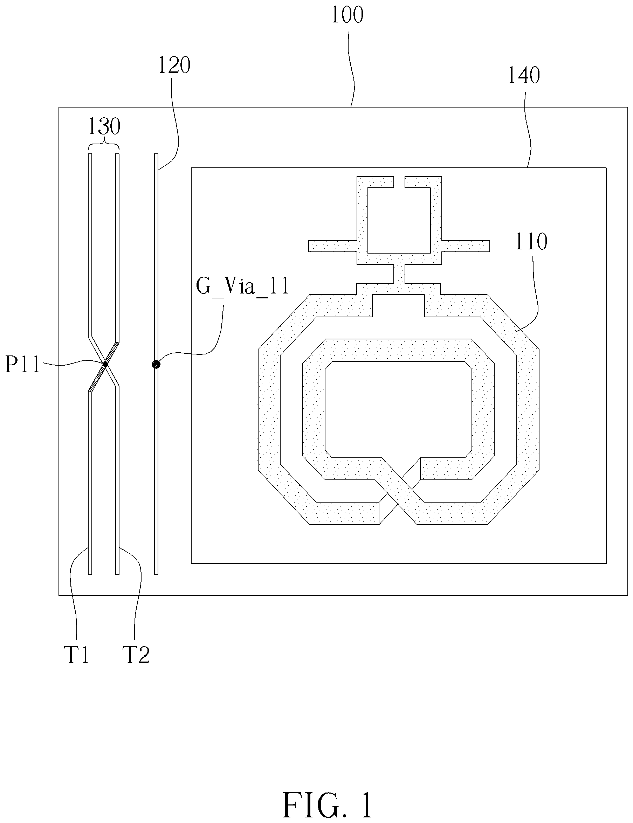

FIG. 1 illustrates an exemplary top view of a semiconductor device according to an embodiment of the invention. The semiconductor device 100 may comprise an electronic device 110, a guard trace 120 and a differential circuit, such as a differential pair 130. In the embodiments of the invention, the electronic device 110 may be an inductive device, such as an inductor, and the electronic device 110 may be one of the components forming a resonant cavity in the semiconductor device 100. As an example, the electronic device 110 may be an inductive device or an inductor which is capable of forming a resonant cavity with a capacitor. In one embodiment of the invention, the electronic device 110 may be an inductor comprised in an Inductance Capacitance Voltage Controlled Oscillator (LC-VCO).

It is to be noted FIG. 1 presents a simplified diagram of a semiconductor device in which only the components relevant to the invention are shown. As will be readily appreciated by a person of ordinary skill in the art, a semiconductor device may further comprise other components not shown in FIG. 1 and configured for implementing the corresponding functions thereof, such as the aforementioned capacitor and/or the components other than an inductor comprised in an LC-VCO. Therefore, the components in a semiconductor device should not be limited to what is shown in FIG. 1.

According to an embodiment of the invention, the differential circuit, such as the differential pair 130, may be an aggressor device to the electronic device 110. As an example, when the differential pair 130 is configured to conduct or transmit high-speed signals, such as (but not limited to) clock signals, the electronic device 110 may be greatly interfered by the coupling noise generated or induced by the differential pair 130. A phenomenon of such interference is a notorious problem named VCO phase noise. As mentioned above, moving the aggressor device far away is a known solution, but it will make larger chip area, which leads to higher cost.

In the embodiments of the invention, instead of moving the aggressor device (such as the differential pair 130) far away from victim device (such as the electronic device 110), the aggressor device may be designed to have a twisted structure or may be designed to have a structure, or in some embodiments of the invention comprise a circuit or device, to change a phase or a direction of a current signal conducted thereon or conducted therein, so as to suppress the coupling noise caused by the aggressor device. More details will be discussed in the following paragraphs.

In addition, to further suppress the coupling noise generated or induced by the aggressor device, the semiconductor device 100 may also comprise a surrounding metal 140. In the embodiments of the invention, the surrounding metal 140 may have a closed loop structure and is arranged to surround the electronic device 110 to suppress coupling noise from any aggressor device adjacent to the electronic device 110. That is, in the corresponding preferred embodiments of the invention, the electronic device 110 is encompassed by the surrounding metal 140. Preferably, a projection area of the surrounding metal 140 on a predetermined plane surrounds a projection area of the electronic device 110 on the predetermined plane, where the predetermined plane may be any layer of the semiconductor device 100 or may be a top surface (or plane) or bottom surface (or plane) of the semiconductor device 100.

Preferably, the guard trace 120 may be disposed between the electronic device 110 and the aggressor device, such as the differential circuit or the differential pair 130. Preferably, the electronic device 110 and the aggressor device, such as the differential circuit or the differential pair 130, may be disposed at different sides of the guard trace 120. The guard trace 120 may be connected to a ground layer having a ground potential through a ground via G_Via_11.

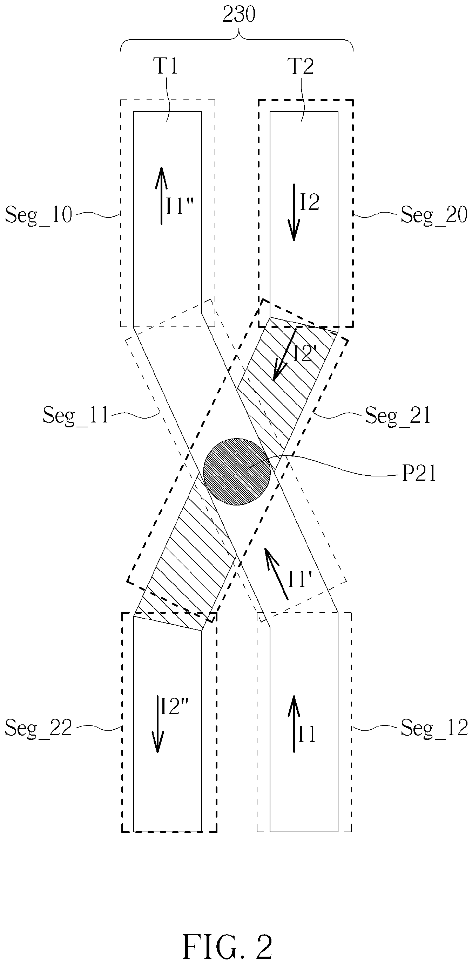

FIG. 2 is a drawing of partial enlargement of a top view of the aggressor device having a twisted structure to suppress the coupling noise induced thereby according to an embodiment of the invention. In this embodiment, the aggressor device is a differential circuit, such as a pair 230, and may comprise traces T1 and T2.

Preferably, the traces T1 and T2 are disposed adjacent to the electronic device (e.g., the electronic device 110 shown in FIG. 1) and the guard trace (e.g., the guard trace 120 shown in FIG. 1). The traces T1 and T2 may be substantially arranged in parallel and may respectively comprise a plurality of portions or segments. As an example, the traces T1 and T2 may extend substantially in parallel along a first direction (e.g., a vertical direction from one end or terminal of the trace T1/T2 to another end or terminal of the trace T1/T2). The traces T1 and T2 may comprise un-twisted portions or segments, such as the upper portions or upper segments Seg_10 and Seg_20 and the lower portions or upper segments Seg_12 and Seg_22, and one or more twisted portions or segments, such as the portions or segments Seg_11 and Seg_21 which are located in the middle of the traces T1 and T2 and are visually overlapped. It is to be noted that although the middle portions or middle segments of the traces T1 and T2 are visually overlapped from the top view of the layout of the semiconductor device as shown in FIG. 2, the traces T1 and T2 are actually physical separated and are electrically disconnected. It is to be also noted that, the twisted portions or segments of a differential pair having a twisted structure is not limited to be located in the middle of the traces. Alternatively preferably, the twisted portions or segments of a differential pair having a twisted structure may be located in any position of the corresponding traces.

Preferably, the layout of the trace T1 and the layout of the trace T2 cross over one another with overlaid intersecting slanting portions or segments, which may also be referred as the twisted portions or segments, such as the segment Seg_11 of the trace T1 and the segment Seg_21 of the trace T2, thereby forming an "X" shaped cross as shown in FIG. 2. In the corresponding preferred embodiments of the invention, a projection area of the segment Seg_11 on the predetermined plane and a projection area of the segment Seg_21 on the predetermined plane are overlapped at a twisting point, such as the twisting point P21 shown in FIG. 2. As noted above, in actual implementation, the traces T1 and T2 are physical separated and are electrically disconnected. Therefore, one of the traces T1 and T2 may have a cross-layer structure. As an example, the segment Seg_21 filled with slashes may be implemented in a layer different from the trace T1 and the segments Seg_20 and Seg_22 of the trace T2.

In the corresponding preferred embodiments of the invention, due to the twisted structure, the relative distance of the current signal conducted on the trace T1 in the differential circuit to the guard trace and the electronic device and the relative distance of the current signal conducted on the trace T2 in the differential circuit to the guard trace and the electronic device are changed or switched during the travel in the respective trace.

To be more specific, assuming that the guard trace and the electronic device are disposed at the right side of the differential pair 230, for the portions or segments above the twisting point P21, the upper portion or upper segment Seg_20 is the one closer to the guard trace and the electronic device, while for the portions or segments below the twisting point P21, the lower portion or lower segment Seg_12 is the one closer to the guard trace and the electronic device.

FIG. 2 also shows the flows of current signals conducted on the traces T1 and T2. The current signal I1 (as well as I1' and I1") is the current signal conducted on the trace T1 and the current signal I2 (as well as I2' and I2") is the current signal conducted on the trace T2. The current signal I1 and the current signal I1' are actually the same current signal with different flowing directions and/or phase. The current signal I1' and the current signal I1" are actually the same current signal with different flowing directions and/or phase. The current signal I1 and the current signal I1" are the same current signal with the same flowing direction (e.g., flowing upward in the vertical direction) but different relative distance to the guard trace and the electronic device. Similarly, the current signal I2 and the current signal I2' are actually the same current signal with different flowing directions and/or phase. The current signal I2' and the current signal I2" are actually the same current signal with different flowing directions and/or phase. The current signal I2 and the current signal I2" are the same current signal with the same flowing direction (e.g., flowing downward in the vertical direction) but different relative distance to the guard trace and the electronic device.

Therefore, in the corresponding preferred embodiments of the invention, the phase and/or the direction of the current signal I1 (as well as I1' and I1") conducted on the trace T1 is changed in the segment Seg_11 (e.g. the current signal I1' with a phase and/or flowing direction different from that of the current signals I1 and 11") and the phase and/or the direction of the current signal I2 (as well as I2' and I2") conducted on the trace T2 is changed in the segment Seg_21 (e.g. the current signal I2' with a phase and/or flowing direction different from that of the current signals I2 and I2").

Once the direction of a current signal changes, the phase of the current signal changes as well. Therefore, in the corresponding preferred embodiments of the invention, for the portions or segments that are relatively closer to the guard trace and the electronic device, such as the upper portion or upper segment Seg_20 and the lower portion or lower segment Seg_12, since the current signals, such as the current signals I2 and I1, conducted thereon have different directions and/or phases, directions of the magnetic fields or magnetic lines induced by the current signals I1 and I2 are different. For example, the directions of the magnetic fields or magnetic lines induced by the current signals I1 and I2 are opposite. In this manner, the magnetic fields or magnetic lines induced by the current signals I1 and I2 may weaken or even cancel each other. Similar phenomenon of being weakened or even cancelled may also occur to the magnetic fields or magnetic lines induced by the current signals I1" and I2" conducted on the traces having the twisted structure. In this manner, the induced coupling noise is effectively suppressed. Note that hereinafter the terms "segment" and "segments" are utilized to respectively represent the description of "portion or segment" and "portions or segments" for brevity.

Referring to both FIG. 1 and FIG. 2, preferably, the ground via G_Via_11 may be arranged beside the segments Seg_11 and Seg_21, and may be preferably arranged beside the twisting point, such as the twisting point P11 shown in FIG. 1 and/or the twisting point P21 shown in FIG. 2. Preferably, as the guard trace 120 and the traces T1 and T2 extend along a first direction (e.g., a vertical direction from one end or terminal of the trace T1/T2 to another end or terminal of the trace T1/T2), the ground via G_Via_11 may be arranged aside the segments Seg_11 and Seg_21 along a second direction (e.g., a horizontal direction) substantially perpendicular to the first direction. Preferably, the ground via G_Via_11 may be arranged aside the twisting point P11/P21 along the second direction that is substantially perpendicular to the first direction.

In a preferred embodiment of the invention, the ground via G_Via_11 may be located at a position on the guard trace 120 that is neighboring to the segments Seg_11 and Seg_21. Preferably, in another or the same preferred embodiment of the invention, the ground via G_Via_11 may be located at a position on the guard trace 120 that is closest to the twisting point, such as the twisting point P11 shown in FIG. 1 and/or the twisting point P21 shown in FIG. 2. Note that in other preferred embodiments of the invention, the position of the ground via G_Via_11 may also be flexibly adjusted. Since the guard trace and the ground via G_Via_11 are utilized to further enhance the suppression of the coupling noise, the position of the ground via G_Via_11 on the guard trace 120 may be chosen to a place to maximize the enhancement of coupling noise suppression, and is not limited to the position that is neighboring, aside, or closest to the segments Seg_11 and Seg_21 or the twisting point P11. Note further that since a semiconductor device may further comprise other components not shown in FIG. 1 for implementing the corresponding functions, the position of the guard trace and the position of the ground via may be flexibly chosen to a place to maximize the enhancement of coupling noise suppression, as well as the distance between the guard trace and the aggressor device, the distance between the guard trace and the electronic device and the distance between the aggressor device and the electronic device may be flexibly adjusted based on the circuit design requirement. Therefore, the aforementioned positions and the aforementioned distances are certainly not the limit of the invention.

It is also to be noted that although in the embodiment shown in FIG. 1, the guard trace 120 and the electronic device 110 are disposed at the right side of the aggressor device, such as the differential pair 130/230, the invention should not be limited thereto. In other embodiments of the invention, the guard trace and the aggressor device may be disposed in anywhere adjacent to the victim electronic device.

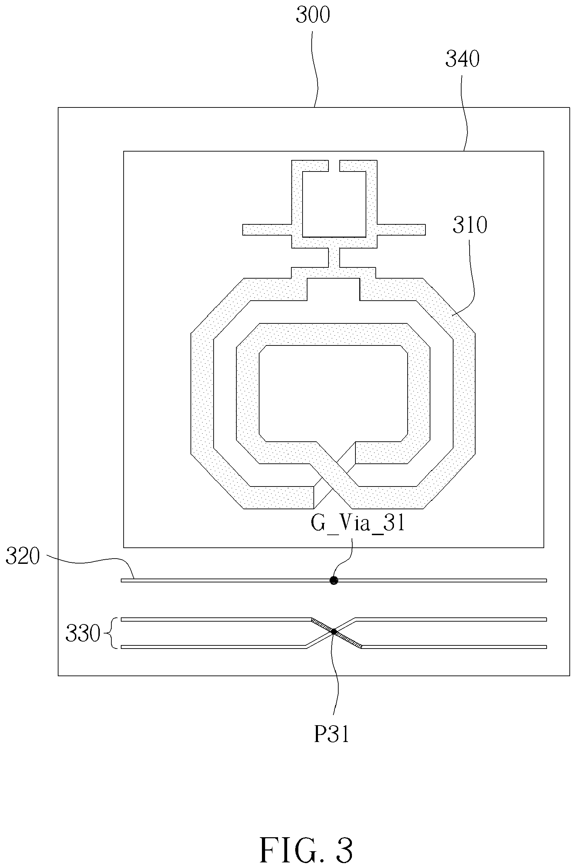

FIG. 3 illustrates an exemplary top view of a semiconductor device according to another embodiment of the invention. The semiconductor device 300 may comprise an electronic device 310, a guard trace 320, a differential pair 330 and a surrounding metal 340. The guard trace 320 may be connected to a ground layer having a ground potential through the ground via G_Via_31 and the differential pair 330 may have a twisted structure with a twisting point P31. In this embodiment, the guard trace 320 and the differential pair 330 are disposed at a different side of the electronic device as compared to the embodiment shown in FIG. 1.

It is to be noted that most of the elements shown in FIG. 3 are the same as in FIG. 1, and the only difference may be in the positions of the guard trace 320 and the differential pair 330 relative to the electronic device 310. Since like reference numerals in FIG. 3 refer to like features in FIG. 1, details with respect to like elements in FIG. 3 may refer to the descriptions regarding FIG. 1 and FIG. 2, and will not be repeated herein.

It is also to be noted that although there is one crossover as well as one twisting point in the embodiments shown in FIG. 1, FIG. 2 and FIG.3, a specific number of crossover and twisting points should not be a limit of the invention. In other embodiments of the invention, there may be more than one crossover and more than one twisting point comprised in the twisted structure, and therefore, there may be more than two un-twisted portions or segments comprised in each trace and more than one twisted portion or segment comprised in the corresponding trace.

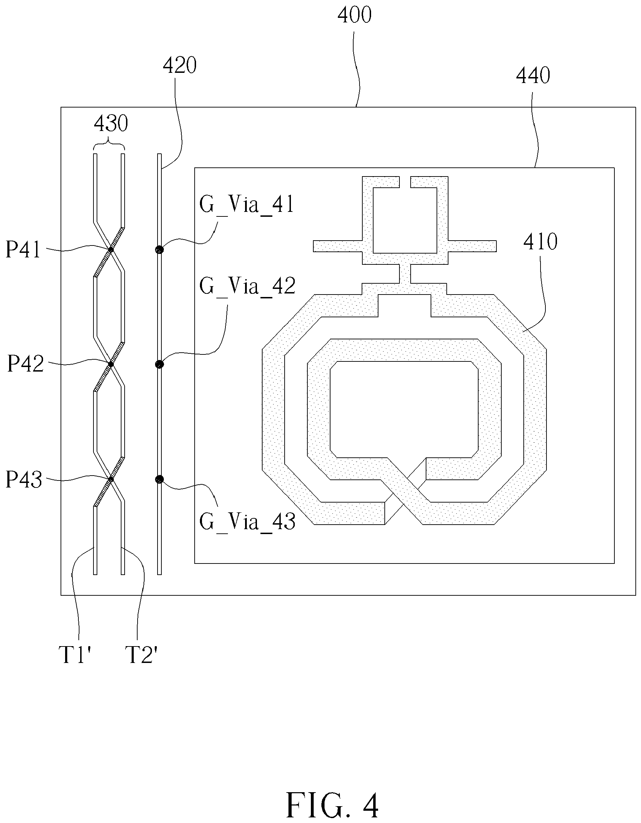

FIG. 4 illustrates an exemplary top view of a semiconductor device according to yet another embodiment of the invention. The semiconductor device 400 may comprise an electronic device 410, a guard trace 420, a differential pair 430 and a surrounding metal 440. In this embodiment, the differential pair 430 comprises traces T1' and T2' and has a twisted structure with three crossovers and three twisting points P41, P42 and P43. To further enhance the suppression of the coupling noise, the guard trace 420 also comprises three ground vias G_Via_41, G_Via_42 and G_Via_43 and is connected to a ground layer having a ground potential through the ground vias.

In this embodiment, the phase or the direction of the current signal conducted on the trace T 1' is substantially the same in the corresponding un-twisted segments, and will be changed in the first twisted segment of the trace T1' corresponding to the twisting point P41, and then changed in the second twisted segment of the trace T1' corresponding to the twisting point P42, and further changed in the third twisted segment of the trace T1' corresponding to the twisting point P43 (when it is assumed that the current signal conducted on the trace T 1' flows downward). Likewise, the phase or the direction of the current signal conducted on the trace T2' is substantially the same in the corresponding un-twisted segments, and will be changed in the third twisted segment of the trace T2' corresponding to the twisting point P43, and then changed in the second twisted segment of the trace T2' corresponding to the twisting point P42, and further changed in the first twisted segment of the trace T2' corresponding to the twisting point P41 (when it is assumed that the current signal conducted on the trace T2' flows upward).

According to a preferred embodiment of the invention, the ground vias G_Via_41 may be located at a position on the guard trace 420 that is beside or neighboring to the first intersecting slanting segments (e.g., the first twisted segments corresponding to the twisting point P41). Preferably, in another or the same preferred embodiment of the invention, the ground via G_Via_41 may be located at a position on the guard trace 420 that is closest to the twisting point P41. Similarly, the ground vias G_Via_42 may be located at a position on the guard trace 420 that is beside or neighboring to the second intersecting slanting segments (e.g., the second twisted segments corresponding to the twisting point P42). Preferably, in an embodiment of the invention, the ground via G_Via_42 may be located at a position on the guard trace 420 that is closest to the twisting point P42. Likewise, the ground vias G_Via_43 may be located at a position on the guard trace 430 that is beside or closest to the third intersecting slanting segments (e.g., the third twisted segments corresponding to the twisting point P43). Preferably, in an embodiment of the invention, the ground via G_Via_43 may be located at a position on the guard trace 420 that is closest to the twisting point P43.

Since most of the elements shown in FIG. 4 are the same as in FIG. 1, and the only difference may be in the number of ground vias and twisting points, like reference numerals in FIG. 4 refer to like features in FIG. 1. Details with respect to like elements in FIG. 4 may refer to the descriptions regarding FIG. 1 and FIG. 2, and will not be repeated herein.

It is to be noted that although the differential pairs are provided in the abovementioned embodiments as the aggressor device, the invention should not be limited thereto. In other embodiments of the invention, the aggressor device to the electronic device may also be a single-ended transmission line or trace (hereinafter the term "trace" is utilized to represent the description of "transmission line or trace" for brevity). In the applications where the aggressor device is a single-ended trace, the single-ended trace may comprise a circuit or device to change a phase or a direction of a current signal conducted thereon, so as to suppress the coupling noise caused by the single-ended trace.

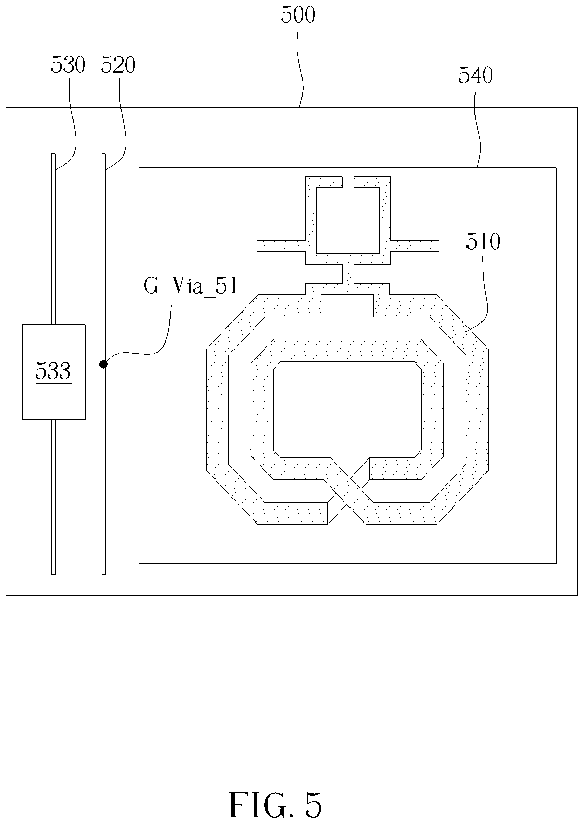

FIG. 5 illustrates an exemplary top view of a semiconductor device according to yet another embodiment of the invention. The semiconductor device 500 may comprise an electronic device 510, a guard trace 520, a single-ended trace 530 and a surrounding metal 540. The guard trace 520 may be connected to a ground layer having a ground potential through the ground via G_Via_51 and the single-ended trace 530 may comprise an inverter circuit 533 configured thereon to change the direction or phase of the current signal conducted on the single-ended trace 530.

In the corresponding preferred embodiments of the invention, there may be a phase difference around 180 degree in the current signal between two sides of the inverter circuit 533, as an example, a phase difference around 180 degree at an operation frequency of the semiconductor device, where the phase is related to the operation frequency of the semiconductor device 500. In addition, in the corresponding preferred embodiments of the invention, the ground via G_Via_51 may be located at a position on the guard trace 520 that is beside or neighboring to the inverter circuit 533. Note that the position of the single-ended trace 530 on where the inverter circuit 533 is located may also be regarded as a portion or a segment of the single-ended trace 530. Therefore, in the corresponding preferred embodiments of the invention, the ground via G_Via_51 may be located at a position on the guard trace 520 that is beside or neighboring to the segment comprising the inverter circuit 533, and the phase or the direction of a current signal conducted on the single-ended trace 530 is changed in the aforementioned segment comprising the inverter circuit 533. Preferably, in a preferred embodiment of the invention, the ground via G_Via_51 may be located at a position on the guard trace 520 that is closest to the point where the phase or the direction of the current signal conducted on the single-ended trace 530 is changed. In another or the same preferred embodiment of the invention, the ground via G_Via_51 may be arranged aside the inverter circuit 533 or the segment comprising the inverter circuit 533 along a second direction (e.g., a horizontal direction in FIG. 5) substantially perpendicular to the first direction (e.g., a vertical direction in FIG. 5) in which the guard trace 520 and the single-ended trace 530 extend.

Note that in other preferred embodiments of the invention, the position of the ground via G_Via_51 may also be flexibly adjusted. Since the guard trace and the ground via are utilized to further enhance the suppression of the coupling noise, the position of the ground via G_Via_51 may be chosen to a place to maximize the enhancement of coupling noise suppression. In addition, since a semiconductor device may further comprise other components not shown in FIG. 5 for implementing the corresponding functions, the position of the guard trace and the position of the ground via may be flexibly chosen to a place to maximize the enhancement of coupling noise suppression, as well as the distance between the guard trace and the aggressor device, such as the single-ended trace, the distance between the guard trace and the electronic device and the distance between the aggressor device and the electronic device may be flexibly adjusted based on the circuit design requirement. Therefore, the aforementioned positions and the aforementioned distances are certainly not the limit of the invention.

It is to be noted that most of the elements shown in FIG. 5 are the same as in FIG. 1, and the only difference may be in the type of the aggressor device to the electronic device 510. Since like reference numerals in FIG. 5 refer to like features in FIG. 1, details with respect to like elements may refer to the descriptions regarding FIG. 1 and FIG. 2, and will not be repeated herein. It is to be further noted that a person of ordinary skill in the art will be readily appreciated to deduce the changes in the flowing direction of the current signal conducted on the single-ended trace comprising one or more inverter circuits based on the illustration regarding FIG. 2 and the description above, therefore, details regarding the direction of current flow on the single-ended trace with one or more inverter circuits are omitted here for brevity.

In the corresponding preferred embodiments of the invention, by changing the direction or phase of a current signal conducted on the single-ended trace during the travel in the single-ended trace, the magnetic fields or magnetic lines induced by the current signal when the current signal is flowing through different segments (such as the segment located above the inverter circuit and the segment located below the inverter circuit) may weaken or even cancel each other. In this manner, the induced coupling noise is effectively suppressed.

It is to be noted that although there is one inverter circuit in the embodiment shown in FIG. 5, a specific number of inverter circuit should not be a limit of the invention. In other embodiments of the invention, there may be more than one inverter circuit comprised in the single-ended trace.

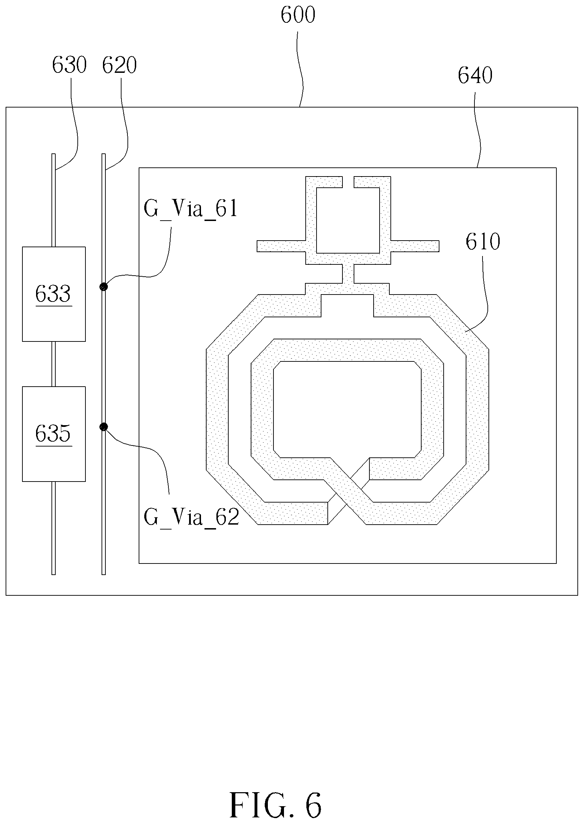

FIG. 6 illustrates an exemplary top view of a semiconductor device according to yet another embodiment of the invention. The semiconductor device 600 may comprise an electronic device 610, a guard trace 620, a single-ended trace 630 and a surrounding metal 640. In this embodiment, the single-ended trace 630 comprises two inverter circuits 633 and 635. To further enhance the suppression of the coupling noise, the guard trace 620 also comprises two ground vias G_Via_61 and G_Via_62 and is connected to a ground layer having a ground potential through the ground vias.

The inverter circuits 633 and 635 are both configured on the single-ended trace 630 to change the direction or phase of the current signal conducted on the single-ended trace 630. In the corresponding preferred embodiments of the invention, there may be a phase difference around 180 degree in the current signal between two sides of the inverter circuit 633, and a phase difference around 180 degree in the current signal between two sides of the inverter circuit 635. As an example, a phase difference around 180 degree at an operation frequency of the semiconductor device 600, where the phase is related to the operation frequency of the semiconductor device 600. In addition, in the corresponding preferred embodiments of the invention, the ground via G_Via_61 may be located at a position on the guard trace 620 that is beside or neighboring to the inverter circuit 633, and the ground via G_Via_62 may be located at a position on the guard trace 620 that is beside or neighboring to the inverter circuit 635. Note that the position of the single-ended trace 630 on where an inverter circuit is located may also be regarded as a portion or a segment of the single-ended trace 630. Therefore, in the corresponding preferred embodiments of the invention, the ground via G_Via_61 may be located at a position on the guard trace 620 that is beside or neighboring to the segment comprising the inverter circuit 633 and the phase or the direction of a current signal conducted on the single-ended trace 630 is changed in the segment comprising the inverter circuit 633, and the ground via G_Via_62 may be located at a position on the guard trace 620 that is beside or neighboring to the segment comprising the inverter circuit 635 and the phase or the direction of the current signal conducted on the single-ended trace 630 is further changed in the segment comprising the inverter circuit 635. Preferably, in a preferred embodiment of the invention, the ground via G_Via_61 may be located at a position on the guard trace 620 that is closest to the point where the phase or the direction of the current signal conducted on the single-ended trace 630 is changed, and the ground via G_Via_62 may be located at a position on the guard trace 620 that is closest to the point where the phase or the direction of the current signal conducted on the single-ended trace 630 is further changed.

In a corresponding preferred embodiment of the invention, the ground via G_Via_61 may be arranged aside the inverter circuit 633 or the segment comprising the inverter circuit 633 along a second direction (e.g., a horizontal direction in FIG. 6) substantially perpendicular to the first direction (e.g., a vertical direction in FIG. 6) in which the guard trace 620 and the single-ended trace 630 extend, and the ground via G_Via_62 may also be arranged aside the inverter circuit 635 or the segment comprising the inverter circuit 635 along the second direction.

In the embodiments of the invention, the electronic device comprised in the semiconductor device and being interfered by the aggressor device (such as a differential pair or a single-ended trace) may be any shape of inductive device and/or inductor that is suitable to provide an inductance. Therefore, although the spiral-shape inductors are shown in the drawings for illustration, the spiral-shape should not be a limit of the invention.

In the embodiments of the invention, by changing the direction or phase of a current signal conducted on the trace during the travel in the trace, the magnetic fields or magnetic lines induced by the current signal when it is flowing in different segments may weaken or even cancel each other. Such phenomenon of being weakened or even cancelled will be generated in both the traces of a differential pair having the twisted structure and a single-ended trace. In this manner, the induced coupling noise is effectively suppressed.

Those skilled in the art will readily observe that numerous modifications and alterations of the device and method may be made while retaining the teachings of the invention. Accordingly, the above disclosure should be construed as limited only by the metes and bounds of the appended claims.

## Claims

1. A semiconductor device (100; 300; 400; 500; 600), comprising:
an electronic component (110; 310; 410; 510; 610);
a guard trace (120; 320; 420; 520; 620), connecting to a ground layer through a first ground via (G_Via_11; G_Via_31 G;_Via_41; G_ Via_51; G_Via_61); and
a first trace (T1; T1'; 530; 630), disposed adjacent to the electronic component (110; 310; 410; 510; 610) and the guard trace (120; 320; 420; 520; 620) and comprising a first segment (Seg_11; 533; 633), wherein a phase or a direction of a first current signal conducted on the first trace (T1; T1'; 530; 630) is changed in the first segment (Seg_11; 533; 633), and
wherein the electronic component (110; 310; 410; 510; 610) and the first trace (T1; T1'; 530; 630) are disposed at different sides of the guard trace (120; 320; 420; 520; 620) and the first ground via (G_Via_11; G_Via_31 G;_Via_41; G_Via_51; G_Via_61) is beside the first segment (Seg_11; 533; 633).

2. The semiconductor device (100; 300; 400; 500; 600) of claim 1, wherein
the electronic component (110; 310; 410; 510; 610) is an electronic device, in particular an inductive device, or an inductor; and/or
the first trance (T1; T1'; 530; 630) is or represents a differential circuit that is disposed adjacent to the electronic component (110; 310; 410; 510; 610) and the guard trace (120; 320; 420; 520; 620) and comprises the first segment (Seg_11; 533; 633), wherein a phase or a direction of the first current signal conducted in the differential circuit is changed in the first segment (Seg_11; 533; 633); and/or
the guard trace (120; 320; 420; 520; 620) extends along a first direction, and the first ground via (G_Via_11; G_Via_31 G;_Via_41; G_Via_51; G_Via_61) is arranged aside the first segment (Seg_11; 533; 633) along a second direction substantially perpendicular to the first direction.

3. The semiconductor device (100; 300; 400; 500; 600) of claim 1 or 2, wherein the first ground via (G_Via_11; G_Via_31 G;_Via_41; G_Via_51; G_Via_61) is located at a position on the guard trace (120; 320; 420; 520; 620) that is neighboring to the first segment (Seg_11; 533; 633).

4. The semiconductor device (100; 300; 400) of any one of claims 1 to 3, further comprising:
a second trace (T2; T2'), disposed adjacent to the electronic component (110; 310; 410) and the guard trace (120; 320; 420) and comprising a second segment (Seg_21), wherein a phase or a direction of a second current signal conducted on the second trace (T2; T2') is changed in the second segment (Seg_21), and
wherein the first trace (T1; T1') and the second trace (T2; T2') form a differential pair (130; 230; 330; 430) and the first ground via (G_Via_11; G_Via_31 G;_Via_41) is beside the second segment (Seg_21).

5. The semiconductor device (100; 300; 400) of any one of claims 1 to 3, wherein the first trace (T1; T1') is part of a/the differential circuit that comprises:
the first trace (T1; T1'), comprising the first segment (Seg_11), wherein the first current signal is conducted on the first trace (T1; T1'); and
a second trace (T2; T2'), comprising a second segment (Seg_21), wherein a phase or a direction of a second current signal conducted on the second trace (T2; T2') is changed in the second segment (Seg_21), and
wherein the first trace (T1; T1) and the second trace (T2; T2') form a differential pair (130; 230; 330; 430) and the first ground via (G_Via_11; G_Via_31 G;_Via_41) is beside the first segment (Seg_11) and the second segment (Seg_21).

6. The semiconductor device (100; 300; 400) of claim 4 or 5, wherein a layout of the first trace (T1; T1') and a layout of the second trace (T2; T2') cross over one another.

7. The semiconductor device (100; 300; 400) of any one of claims 4 to 6, wherein a projection area of the first segment (Seg_11) on a predetermined plane and a projection area of the second segment (Seg_21) on the predetermined plane are overlapped at a first twisting point (P11; P_21; P31; P41).

8. The semiconductor device (100; 300; 400) of any one of claims 4 to 7, further comprising:
a second ground via (G_Via_42), connecting the guard trace (120; 320; 420) to the ground layer,
wherein the phase or the direction of the first current signal conducted on the first trace (T1; T1') is further changed in a third segment, the phase or the direction of the second current signal conducted on the second trace (T2; T2') is further changed in a fourth segment, the second ground via (G_Via_42) is beside the third segment and the fourth segment and a projection area of the third segment on a predetermined plane and a projection area of the fourth segment on the predetermined plane are overlapped at a second twisting point (P42).

9. The semiconductor device (500; 600) of any one of claims 1 to 3, further comprising:
a first inverter circuit (533; 633), disposed on the first trace (530; 630) to change the direction or the phase of the first current signal.

10. The semiconductor device (500; 600) of claim 9, wherein there is a phase difference around 180 degree at an operation frequency of the semiconductor device (500; 600) in the first current signal between two sides of the first inverter circuit (533; 633).

11. The semiconductor device (600) of claim 9 or 10, further comprising:
a second ground via (G_Via_62), connecting the guard trace (620) to the ground layer; and
a second inverter circuit (635), disposed on the first trace (630) to change the direction or the phase of the first current signal,
wherein the first ground via (G_Via_61) is located at a position on the guard trace (620) that is neighboring to the first inverter circuit (633) and the second ground via (G_Via_62) is located at a position on the guard trace (620) that is neighboring to the second inverter circuit (635).

12. The semiconductor device (500; 600) of any one of claims 1 to 3, wherein the first trance (530; 630) is or represents a/the differential circuit, and wherein the semiconductor device (500; 600) further comprises:
a first inverter circuit (533; 633), disposed in the differential circuit (530; 630) to change the direction or the phase of the first current signal.

13. The semiconductor device (500; 600) of claim 12, wherein there is a phase difference around 180 degree at an operation frequency of the semiconductor device (500; 600) in the first current signal between two sides of the first inverter circuit (533; 633).

14. The semiconductor device (600) of claim 12 or 13, further comprising:
a second ground via (G_Via_62), connecting the guard trace (620) to the ground layer; and
a second inverter circuit (635), disposed in the differential circuit (630) to change the direction or the phase of the first current signal,
wherein the first ground via (G_Via_61) is located at a position on the guard trace (620) that is neighboring to the first inverter circuit (633) and the second ground via (G_Via_62) is located at a position on the guard trace (620) that is neighboring to the second inverter circuit (635).

15. The semiconductor device (100; 300; 400; 500; 600) of any one of claims 1 to 14, further comprising:
a surrounding metal (140; 340; 440; 540; 640), having a closed loop structure,
wherein a projection area of the surrounding metal (140; 340; 440; 540; 640) on a predetermined plane surrounds a projection area of the electronic component (110; 310; 410; 510; 610) on the predetermined plane.
